# EUROPEAN PATENT SPECIFICATION

(11) **EP 3 005 428 B1**
(45) Date of publication and mention of the grant of the patent: **25.05.2022**
(21) Application number: 14733925.3
(22) Date of filing: 03.06.2014
(51) Int. Cl.: H01L 33/40, H01L 33/38

(54) **LIGHT EMITTING DIODE DIELECTRIC MIRROR**
DIELEKTRISCHER SPIEGEL MIT LICHTEMITTIERENDEN DIODEN
MIROIR DIÉLECTRIQUE DE DIODE ÉLECTROLUMINESCENTE

(30) Priority: 04.06.2013 US 201313909927
(43) Date of publication of application: 13.04.2016
(73) Proprietor: CreeLED, Inc., Newark, CA 94560 (US)
(72) Inventor: HEIKMAN, Sten, Goleta, CA 93117 (US); IBBETSON, James, Santa Barbara, CA 93111 (US)
(74) Representative: Dehns
(86) International application number: PCT/US2014/040757
(87) International publication number: WO 2014/197512

(56) References cited:
- EP-A1- 2 403 025
- JP-A- 2003 017 757
- JP-A- 2010 087 282
- US-A1- 2009 283 787
- US-A1- 2010 171 135
- US-A1- 2012 235 204
- US-A1- 2012 280 263
- KIM JONG KYU ET AL: "GaInN light-emitting diodes with RuO2/SiO2/Ag omni-directional reflector", 31 May 2004 (2004-05-31), APPLIED PHYSICS LETTERS, AMERICAN INSTITUTE OF PHYSICS, US, PAGE(S) 4508 - 4510, XP012061652, ISSN: 0003-6951 abstract figure 3

## Description

This application is a continuation-in-part of, and claims the benefit of, US Patent Application Serial Number 13/071,349, to Ibbetson, et al., filed on March 24, 2011, which is a continuation of and claims the benefit of US Patent Application Serial Number 12/316,097, to Li, et al., filed on December 8, 2008. This application is also a continuation-in-part of, and claims the benefit of, U.S. Patent Application Serial Number 12/463,709, to Denofrio, et al., filed on May 11, 2009, which is also a continuation-in-part of U.S. Patent Application Serial Number 11/985,410, to Keller, et al., filed on November 14, 2007, and a continuation-in-part of U.S. Patent Application Serial Number 12/329,713, to Denofrio, et al. filed on December 8, 2008.

### BACKGROUND OF THE INVENTION

### Field of the Invention

This invention relates to light emitting diodes, and more particularly to light emitting diodes having high reflectivity mirrors.

### Description of the Related Art

Light emitting diodes (LED or LEDs) are solid state devices that convert electric energy to light, and generally comprise one or more active layers of semiconductor material sandwiched between oppositely doped n-type and p-type layers. When a bias is applied across the doped layers, holes and electrons are injected into the active layer where they recombine to generate light. Light is emitted from the active layer and from all surfaces of the LED.

For typical LEDs it is desirable to operate at the highest light emission efficiency, and one way that emission efficiency can be measured is by the emission intensity in relation to the input power, or lumens per watt. One way to maximize emission efficiency is by maximizing extraction of light emitted by the active region or active structure of LEDs. For conventional LEDs with a single out-coupling surface, the external quantum efficiency can be limited by a number of factors, such as total internal reflection (TIR) of light from the LED's emission region. TIR can be caused by the large difference in the refractive index between the LED's semiconductor and surrounding ambient. Some LEDs have relatively low light extraction efficiencies because of the high index of refraction of the substrate compared to the index of refraction for the surrounding material, such as epoxy. This difference results in a small escape cone from which light rays from the active area can transmit from the substrate into the epoxy and ultimately escape from the LED package. Light that does not escape can be absorbed in the semiconductor material or at surfaces that reflect the light.

Different approaches have been developed to reduce TIR and improve overall light extraction, with one of the more popular being surface texturing. Surface texturing increases the light escape probability by providing a varying surface that allows photons multiple opportunities to find an escape cone. Light that does not find an escape cone can continue to experience TIR, and reflects off the textured surface at different angles until it finds an escape cone. The benefits of surface texturing have been discussed in several articles. [See Windisch et al., Impact of Texture-Enhanced Transmission on High-Efficiency Surface Textured Light Emitting Diodes, Appl. Phys. Lett., Vol. 79, No. 15, Oct. 2001, Pgs. 2316-2317; Schnitzer et al. 30% External Quantum Efficiency From Surface Textured, Thin Film Light Emitting Diodes, Appl. Phys. Lett., Vol 64, No. 16, Oct. 1993, Pgs. 2174-2176; Windisch et al. Light Extraction Mechanisms in High-Efficiency Surface Textured Light Emitting Diodes, IEEE Journal on Selected Topics in Quantum Electronics, Vol. 8, No. 2, March/April 2002, Pgs. 248-255; Streubel et al. High Brightness AlGaNInP Light Emitting Diodes, IEEE Journal on Selected Topics in Quantum Electronics, Vol. 8, No. March/April 2002]. U.S. Patent No. 6,657,236, also assigned to Cree Inc., discloses structures formed on the semiconductor layers for enhancing light extraction in LEDs. EP 2403025 discloses an LED chip comprising a dielectric layer between the p-type nitride semiconductor layer and the anode electrode to have an arrangmenet which resembles an island or bump. JP 2010 087282 A, US 2012/280263 A1, US 2010/171135 A1, US 2012/235204 A1, EP 2 403 025 A1, JP 2003 017757 A and US 2009/283787 A1 disclose prior art LEDs comprising reflective contacts. Kim Yong Kyu et al. "GaInN light-emitting diodes with RuO2/SiO2/Ag omnidirectional reflector", Appl. Phys. Lett., 31 May 2004, Pgs. 4508 - 4510 also discloses a prior art LED comprising a reflective contact.

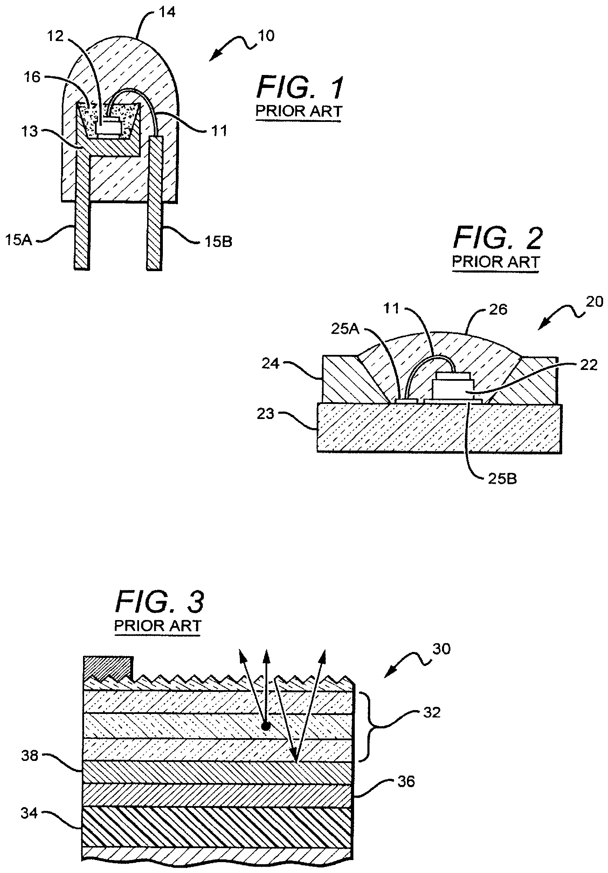

Another way to increase light extraction efficiency is to provide reflective surfaces that reflect light so that it contributes to useful emission from the LED chip or LED package. In a typical LED package 10 illustrated in FIG. 1, a single LED chip 12 is mounted on a reflective cup 13 by means of a solder bond or conductive epoxy. One or more wire bonds 11 can connect the ohmic contacts of the LED chip 12 to leads 15A and/or 15B, which may be attached to or integral with the reflective cup 13. The reflective cup may be filled with an encapsulant material 16 which may contain a wavelength conversion material such as a phosphor. At least some of light emitted by the LED at a first wavelength may be absorbed by the phosphor, which may responsively emit light at a second wavelength. The entire assembly is then encapsulated in a clear protective resin 14, which may be molded in the shape of a lens to collimate the light emitted from the LED chip 12. While the reflective cup 13 may direct light in an upward direction, optical losses may occur when the light is reflected. Some light may be absorbed by the reflector cup due to the less than 100% reflectivity of practical reflector surfaces. Some metals can have less than 95% reflectivity in the wavelength range of interest.

FIG. 2 shows another LED package in which one or more LED chips 22 can be mounted onto a carrier such as a printed circuit board (PCB) carrier, substrate or submount 23. A metal reflector 24 mounted on the submount 23 surrounds the LED chip(s) 22 and reflects light emitted by the LED chips 22 away from the package 20. The reflector 24 also provides mechanical protection to the LED chips 22. One or more wirebond connections 11 are made between ohmic contacts on the LED chips 22 and electrical traces 25A, 25B on the submount 23. The mounted LED chips 22 are then covered with an encapsulant 26, which may provide environmental and mechanical protection to the chips while also acting as a lens. The metal reflector 24 is typically attached to the carrier by means of a solder or epoxy bond. The metal reflector 24 may also experience optical losses when the light is reflected because it also has less than 100% reflectivity.

The reflectors shown in FIGs. 1 and 2 are arranged to reflect light that escapes from the LED. LEDs have also been developed having internal reflective surfaces or layers to reflect light internal to the LEDs. FIG. 3 shows a schematic of an LED chip 30 with an LED 32 mounted on a submount 34 by a metal bond layer 36. The LED further comprises a p-contact/reflector 38 between the LED 32 and the metal bond 36, with the reflector 38 typically comprising a metal such as silver (Ag). This arrangement is utilized in commercially available LEDs such as those from Cree^{®} Inc., available under the EZBrightTM family of LEDs. The reflector 38 can reflect light emitted from the LED chip's active region toward the submount back toward the LED's primary emitting surface. The reflector also reflects TIR light back toward the LED's primary emitting surface. Like the metal reflectors above, reflector 38 reflects less than 100% of light and in some cases less than 95%. The reflectivity of a metal film on a semiconductor layer may be calculated from the materials' optical constants using thin film design software such as TFCalc^{™} from Software Spectra, Inc. (www.sspectra.com).

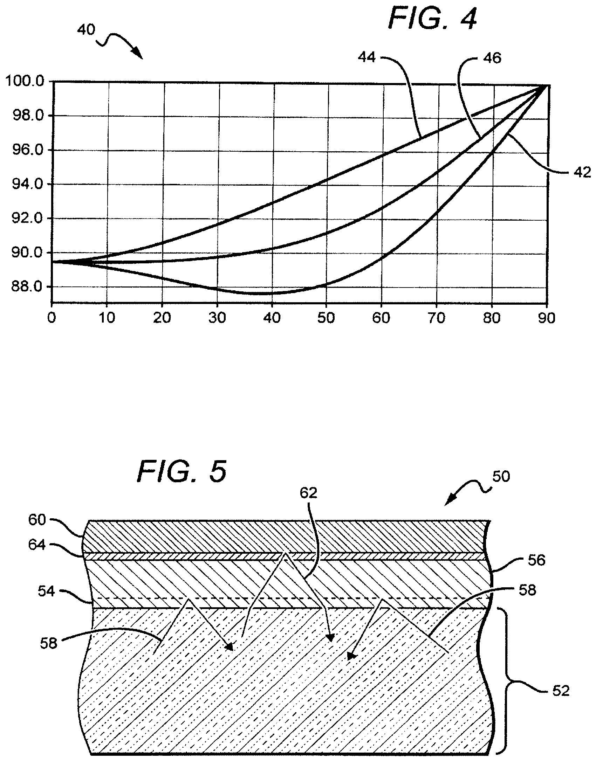

FIG. 4 shows a graph 40 showing the reflectivity of Ag on gallium nitride (GaN) at different viewing angles for light with a wavelength of 460nm. The refractive index of GaN is 2.47, while the complex refractive index for silver is taken from the technical literature. [See Handbook of Optical Constants of Solids, edited by E. Palik.] The graph shows the p-polarization reflectivity 42, s-polarization reflectivity 44, and average reflectivity 46, with the average reflectivity 46 generally illustrating the overall reflectivity of the metal for the purpose of LEDs where light is generated with random polarization. The reflectivity at 0 degrees is lower than the reflectivity at 90 degrees, and this difference can result in up to 5% or more of the light being lost on each reflection. In an LED chip, in some instances TIR light can reflect off the mirror several times before it escapes and, as a result, small changes in the mirror absorption can lead to significant changes in the brightness of the LED. The cumulative effect of the mirror absorption on each reflection can reduce the light intensity such that less than 75% of light from the LED's active region actually escapes as LED light.

### SUMMARY OF THE INVENTION

The present invention provides a light emitting diode (LED) chip as claimed in claim 1.

Embodiments and advantages of the invention will become apparent from the following detailed description and the accompanying drawings, which illustrate by way of example the features of the invention.

### BRIEF DESCRIPTION OF THE DRAWINGS

FIG. 1 is a sectional view of one embodiment of a prior art LED lamp;
FIG. 2 is a sectional view of another embodiment of a prior art LED lamp;
FIG. 3 is a sectional view of another embodiment of a prior art LED chip;
FIG. 4 is a graph showing the reflectivity of a metal reflector at different viewing angles;
FIG. 5 is a sectional view of an LED chip which is provided for the purpose of reference only;
FIG. 6 is a sectional view of an embodiment of an LED chip according to the present invention; and
FIG. 7 is a sectional view of another embodiment of an LED chip according to the present invention.

### DETAILED DESCRIPTION OF THE INVENTION

The present invention is directed to solid-state emitters having internal or integral reflective surfaces/layers arranged to increase the emission efficiency of the emitters. The present invention is described herein with reference to light emitting diodes (LED or LEDs) but it is understood that it is equally applicable to other solid-state emitters. The present invention can be used as a reflector in conjunction with one or more contacts, or can be used as a reflector separate from the contacts.

As described above, different embodiments of light emitting diode (LED) chips according to the present invention comprises an active LED structure having an active layer between two oppositely doped layers. A first reflective layer is provided adjacent to a one of the oppositely doped layers, with the first layer comprising a material with a different index of refraction than the active LED structure. In most embodiments, the first layer can comprise a layer with an IR that is primarily lower at or near its in interface with the active LED structure. Stated differently, when the layer comprises a number of materials, some embodiments of the layer can have an average IR lower than the active LED structure. In still other embodiments, the portion of the reflective layer closest to the active LED structure should be less than the active LED structure, with some embodiments of this closer layer being approximately 2 to 4 angstroms (Å) thick.

The difference in IR between the active LED structure and the first reflective layer increases the amount of TIR light at the junction. In the embodiments where the first reflective layer has an IR lower than the active LED structure, the lower IR material provides a step down in IR that increases the amount of light that can experience TIR. LED chips according to the present invention also comprise a second reflective layer which is a metal layer, that is on and used in conjunction with the first reflective layer such that light passing through the first reflective layer (e.g. not experiencing TIR) can be reflected by the second reflective layer.

These internal or integral reflective layers can reduce optical emission losses that can occur by light being emitted in an undesirable direction where it can be absorbed. Light that is emitted from the emitter's active LED structure in a direction away from useful light emission, such as toward the substrate, submount, or metal reflector can be reflected by the first reflective layer. The reflective surfaces can be positioned to reflect this light so that it emits from the LED chip in a desirable direction. Embodiments of the present invention provide one or a plurality of layers and materials that can cooperate to efficiently reflect light in the desired directions so that it can contribute to the emitter's useful emission.

The first reflective layer comprises a dielectric material such as SiO₂. It is understood that many other dielectric materials can be used with refractive indexes that are lower or higher, with the preferred having an IR that up to approximately 50% smaller than the LED's active structure material. In other embodiments the IR of the first reflective material can be up to approximately 40% smaller than the active structure material, while in other embodiments it can be up to approximately 30% smaller. For example in some embodiments GaN material of the active structure has an IR of 2.4 and the SiO₂ material of the reflective layer has and IR of 1.46. This represents a difference in IR between the two of approximately 39%.

Many conventional LEDs can rely primarily on a metal reflector layer made of different material such as Ag or Au. As described above, there can be losses with each reflection off metal reflectors, and these losses can be significant particularly for light making multiple passes and reflections in the LED. There are no optical losses in light reflected by TIR, so that when more light is reflected using TIR instead of a metal material, the emission efficiency of the LED can increase. Other conventional LEDs chips have relied on internal multiple layer reflectors, such as distributed Bragg reflectors (DBRs), but these reflectors can involve complex and costly manufacturing processes. Utilizing a reflective layer that comprises a single dielectric layer can reduce the overall manufacturing cost and complexity.

Different embodiments of emitters according to the present invention can also utilize other structures, layers or features that allow for efficient and reliable LED operation. A current spreading layer is included in proximity to the reflective layer to provide for spreading of current into the one or more layers of the active LED structure. In other embodiments, materials can be included to provide for reliable adhesion between different layers, such as between the low IR layer and the metal reflective layer. Different embodiments of the invention also provide having conductive via or path arrangements that provide conductive paths through the low IR reflective layer. This allows an electric signal to pass through the low IR layer along the vias so that the composite layer can be used as an internal layer, where an electrical signal can pass through the low IR layer during operation. This via arrangement can take many different shapes and sizes as described in detail below.

The present invention is described herein with reference to certain embodiments but it is understood that the invention can be embodied in many different forms and should not be construed as limited to the embodiments set forth herein. In particular, the lower IR first reflective layer can comprise many different material layers and can have many different thicknesses beyond those described herein. The first reflective layer is described herein as a layer of dielectric material. In some embodiments the first reflective layer may comprise more than one layer. In these multiple layer embodiments, the IR for all the layers can be similar, and in some embodiments less than the IR for the active LED structure. Some embodiments, can have layers having layers or materials with a IR higher than the active LED structure, but these layers can be thin enough to have minimal optical impact. It is understood, that in some embodiments the number of layers in the first reflective layers would typically be less than the number of layers found in reflectors such as DBRs, and in some embodiments the layers would have substantially similar IRs. The first reflective layer can also be in many different locations on different solid-state emitters beyond those described herein, and can be used on different devices beyond solid state emitters. Further, the first reflective layer Z is provided with conductive structures to allow electrical signals to pass through. It is understood that LEDs according to the present invention can also utilize single layer first reflective layer in conjunction with other reflectors such as metal reflective layers or DBR layers. The first reflective layer is arranged to maximize the amount of light reflected by TIR, while at the same time maintaining a simple, efficient and cost effective reflecting system.

It is also understood that when an element such as a layer, region or substrate is referred to as being "on", "adjacent" or "in proximity" to another element, it can be directly on the other element or intervening elements may also be present. Furthermore, relative terms such as "inner", "outer", "upper", "above", "lower", "beneath", and "below", and similar terms, may be used herein to describe a relationship of one layer or another region. It is understood that these terms are intended to encompass different orientations of the device in addition to the orientation depicted in the figures.

Although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Embodiments of the invention are described herein with reference to cross-sectional view illustrations that are schematic illustrations of embodiments of the invention. As such, the actual thickness of the layers can be different, and variations from the shapes of the illustrations as a result, for example, of manufacturing techniques and/or tolerances are expected. Embodiments of the invention should not be construed as limited to the particular shapes of the regions illustrated herein but are to include deviations in shapes that result, for example, from manufacturing. A region illustrated or described as square or rectangular will typically have rounded or curved features due to normal manufacturing tolerances. Thus, the regions illustrated in the figures are schematic in nature and their shapes are not intended to illustrate the precise shape of a region of a device and are not intended to limit the scope of the invention.

FIGs. 5 shows an LED chip 50 not according to the present invention having reflective structure, provided for the purpose of reference only, that allows for LED chip operation with increased emission efficiency. Although the present invention is described with reference to fabrication of a single LED chip it is understood that the present invention can also be applied to wafer level LED fabrication, fabrication of groups of LEDs, or fabrication of packaged LED chips. The wafer or groups of LEDs can then be separated into individual LED chips using known singulation or dicing methods. The present invention can also be used in different LEDs having different geometries, such lateral geometry or vertical geometry. The present invention can also be used in LEDs compatible with flip-chip mounting as well as those that are arranged for non flip-chip mounting.

The LED chip 50 comprises an LED active region or structure 52 that can have many different semiconductor layers arranged in different ways. The fabrication and operation of LEDs and their active stucture are generally known in the art and only briefly discussed herein. The layers of the active structure 52 can be fabricated using known processes with a suitable process being fabrication using MOCVD. The layers of the active structure 52 can comprise many different layers and generally comprise an active layer sandwiched between n-type and p-type oppositely doped epitaxial layers, all of which are formed successively on a growth substrate. It is understood that additional layers and elements can also be included in the active structure 52, including but not limited to buffer, nucleation, contact and current spreading layers as well as light extraction layers and elements. The active layer can comprise single quantum well (SQW), multiple quantum well (MQW), double heterostructure or super lattice structures.

The active structure 52 can be fabricated from different material systems, with preferred material systems being Group-III nitride based material systems. Group-III nitrides refer to those semiconductor compounds formed between nitrogen and the elements in the Group III of the periodic table, usually aluminum (Al), gallium (Ga), and indium (In). The term also refers to ternary and quaternary compounds such as aluminum gallium nitride (AlGaN) and aluminum indium gallium nitride (AlInGaN). In one embodiment, the n- and p-type layers are gallium nitride (GaN) and the active layer comprises InGaN. In alternative embodiments the n- and p-type layers may be AlGaN, aluminum gallium arsenide (AlGaAs) or aluminum gallium indium arsenide phosphide (AlGaInAsP) and related compounds.

The growth substrate can be made of many materials such as sapphire, silicon carbide, aluminum nitride (AlN), GaN, with a suitable substrate being a 4H polytype of silicon carbide, although other silicon carbide polytypes can also be used including 3C, 6H and 15R polytypes. Silicon carbide has certain advantages, such as a closer crystal lattice match to Group III-nitrides than sapphire and results in Group III-nitride films of higher quality. Silicon carbide also has a very high thermal conductivity so that the total output power of Group-III nitride devices on silicon carbide is not limited by the thermal dissipation of the substrate (as may be the case with some devices formed on sapphire). SiC substrates are available from Cree Research, Inc., of Durham, North Carolina and methods for producing them are set forth in the scientific literature as well as in U.S. Patents, Nos. Re. 34,861; 4,946,547; and 5,200,022.

Different embodiments of the active structure can emit different wavelengths of light depending on the composition of the active layer and n- and p-type layers. In some embodiments, the active structure emits a blue light in the wavelength range of approximately 450 to 460nm. The LED chip 50 can also be covered with one or more conversion materials, such as phosphors, such that at least some of the light from the LED passes through the one or more phosphors and is converted to one or more different wavelengths of light. In one embodiment, the LED chip emits a white light combination of light from the LED's active structure and light from the one or more phosphors.

As mentioned above, different layers can be included to allow for efficient operation of the LED chip 50. For some semiconductor materials, such as some Group-III nitride material systems, current does not effectively spread through the p-type layer. A current spreading layer 54 ison the active structure 52 in a location to aid in current spreading into the p-type layer. In some embodiments the current spreading layer 54 can cover some or the entire p-type layer and in some embodiments the current spreading layer 54 helps spread current from a p-type contact across the surface of the p-type layer as described in more detail below. This helps to provide improved current spreading across the p-type layer with a corresponding improvement in current injection from the p-type layer.

The current spreading layer 54 can comprise many different materials and is typically a transparent conductive oxide such as indium tin oxide (ITO) or a metal such as platinum (Pt), although other materials can also be used. The current spreading layer can have many different thicknesses, with the present invention having a thickness small enough to minimize absorption of light from the active structure that passes through the current spreading layer. Some embodiment of current spreading layer 54 comprising ITO, can have thicknesses less than 1000 angstroms (Å), while other embodiments can have a thickness less than 700Å. Still other embodiments can have a thickness less than 500Å. Still other embodiments can have a thickness in the range of 50 to 300Å, with some of these embodiments having current spreading layer with a thickness of approximately 200Å. The current spreading layer 54 as well as the reflective layers described below can be deposited using known methods.

The LED chip 50 also comprises a reflective layer 56 formed on the active structure 52, and formed on the current spreading layer 54 with the current spreading layer between the reflectivity layer 56 and active structure 52. The reflective layer 56 can comprise many different materials and preferably comprises a material that presents an IR step between the material comprising the active structure 52. Stated differently, the reflective layer should have an IR that is smaller than the active structure to promote TIR of active structure light emitting toward the reflective layer 56, as shown by first light trace 58. Light that experiences TIR is reflected without experience absorption or loss, and TIR allows for the efficient reflection of active structure light so that it can contribute to useful or desired LED chip emission. In embodiments that rely on metal layers to reflect light, the light experiences loss with each reflection (as described above), which can reduce overall LED chip emission efficiency.

In some embodiments, the IR for the reflective layer 56 is lower than the IR for the active structure material, with lower IR material providing for increased TIR of active structure light. Many different materials can be used for the reflective layer 56, with some having an IR less than 2.3, while other embodiments can have an IR less than 2.15. In still other embodiments the IR can be less than 2.0. The reflective layer 56 is a dielectric, with some embodiments comprising SiO₂. It is understood that other dielectric materials can be used such as SiN, Si, Ge, MgOx, MgNx, ZnO, SiNx, SiOx, AlN, and alloys or combinations thereof.

As mentioned above, some Group III nitride materials such as GaN can have an IR of approximately 2.4, and SiO₂ has an IR of approximately 1.46. Embodiments with an active LED structur 52 comprising GaN and that also comprises a SiO₂ reflective layer, can have a sufficient IR step between the two to allow for efficient TIR of light at the junction between the two as shown by light traces 58. The reflective layer 56 can have different thicknesses depending on the type of material, having a thickness of at least 0.3 microns (µm). It has a thickness in the range of 0.3 to 0.7µm, while in some of these embodiments it can be approximately 0.5µm thick.

As light experiences TIR at the junction with the reflective layer 56 an evanescent wave with exponentially decaying intensity can extend into the reflective layer 56. This wave is most intense within approximately one third of the light wavelength from the junction (about 0.3um for 450nm light in SiO2). If the thickness of the reflective layer 56 is too thin, such that significant intensity remains in the evanescent wave at the interface between the first reflective layer 56 and the second reflective layer 60, a portion of the light can reach the second reflective layer 60. This in turn can reduce the TIR reflection at the first interface. For this reason, the reflective layer 56 has a thickness of at least 0.3um.

As mentioned above, the LED chips 50 can also utilize a second reflective layer, which is a metal layer 60, to reflect light that does not experience TIR at the junction with the reflective layer 56 and passes through the reflective layer 56. An example of the light reflected at the metal layer is shown by second light trace 62, which passes first through the reflective layer 56 before being reflected at the metal layer. The metal layer 60 can comprise many different materials such as Ag, Au, Al, or combinations thereof. The present invention also comprises an adhesion layer 64 between the reflective layer 54 and the metal layer 60 to promote adhesion between the two. Many different materials can be used for the adhesion layer 64, such as TiO, TiON, TiO₂, TaO, TaON, Ta₂O₅, AlO or combinations thereof, with a preferred material being TiON. The adhesion layer can have many different thicknesses from just a few Å to thousands of Å. In some embodiments it can be less than 100Å, while in other embodiments it can be less than 50Å. In some of these embodiments it can be approximately 20Å thick. The thickness of the adhesion layer 64 and the material used should minimize the absorption of light passing to minimize losses of light reflecting off the metal layer 60.

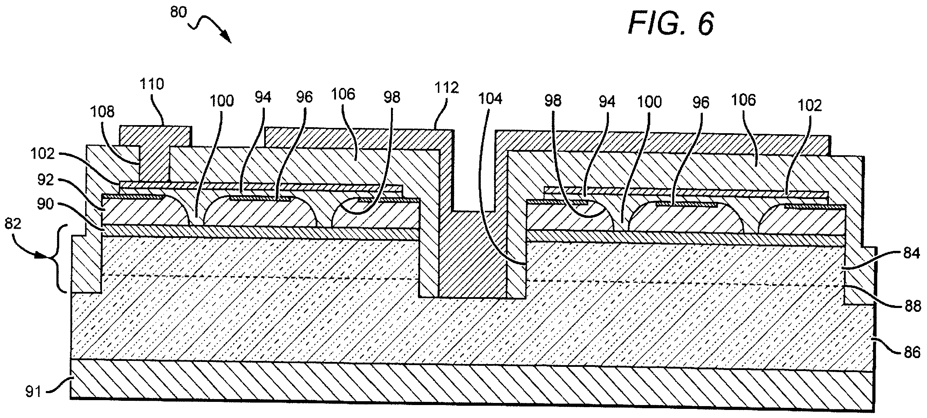

It is understood that the reflective layer arrangements described above can be used in many different LED chips according to the present invention. FIG. 6 shows an embodiment of an LED chip 80 according to the present invention having a lateral geometry and arranged for flip-chip mounting. The LED chip 80 comprises a GaN active structure 82 having a p-type layer 84, n-type layer 86 and an active layer 88 formed on a substrate 91. The substrate 91 can comprise many different materials such as silicon carbide or sapphire, and can be shaped or textured to enhance light extraction such as the substrate shaping utilized in commercially available DA line of LEDs from Cree, Inc.

The LED chip 80 also comprises a current spreading layer 90 that is on the p-type layer 84. The current spreading layer 90 can have the same thickness and can comprise the same materials as the current spreading layer 54 shown in FIG. 5 and described above. In LED chip 80, the current spreading layer 90 can comprise ITO and is on the p-type layer 84 to spread current into the p-type layer. A low IR reflective layer 92 is arranged on the current spreading layer 90, and can have the same thickness and can comprise the same material as reflective layer 56 described above. In LED chip 80 the reflective layer can comprise SiO₂. A metal layer 94 and adhesion layer 96 are included on the reflective layer 92, with the adhesion layer 96 sandwiched between and providing adhesion between the metal layer 94 and reflective layer 92. These layers can comprise the same material and can have the same thickness as the metal layer 94 and adhesion layer 96 described above.

The LED chip 80 further comprises reflective layer holes 98 that passes through the adhesion layer 96 and the reflective layer 92, to the current spreading layer 90. The holes 98 can then be filled when the metal layer 94 is deposited, the metal layer material forms vias 100 to the current spreading layer. As described in more detail below, the vias 100 provide a conductive path through the reflective layer, between the p-contact and the current spreading layer 90.

The holes 98 can be formed using many known processes such as conventional etching processes or mechanical processes such as microdrilling. The holes 98 can have many different shapes and sizes, with the holes 98 in the embodiment shown having angled or curved side surfaces and a circular cross-section with a diameter of less than 20µm. In some embodiments, the holes can have a diameter of approximately 8µm, with others having a diameter down to 1µm. Adjacent holes 98 can be less than 100µm apart, with the embodiment shown having a spacing of 30µm spacing from edge to edge. In still other embodiments, the vias can have a spacing of as low as 10pm or less. It is understood that the holes 98 (and resulting vias 100) can have cross-section with different shapes such as square, rectangular, oval, hexagon, pentagon, etc. In other embodiments the holes are not uniform size and shapes and there can be different or nonuniform spaces between adjacent holes.

In other embodiments (not within the scope of the present claims) different structures can be used to provide a conductive path between the p-contact and the current spreading layer. Instead of holes an interconnected grid can be formed through the reflective layer 92, with a conductive material then being deposited in the grid to form the conductive path through the composite layer. The grid can take many different forms, with portions of the grid interconnecting at different angles in different embodiments. An electrical signal applied to the grid can spread throughout and along the interconnected portions. It is further understood that in different embodiments a grid can be used in combination with holes, while other embodiments can provide other conductive paths. In some embodiments one or more conductive paths can run outside the LED chip's active layer such as along a side surface of the LED chip.

The LED chip 80 also comprises a barrier layer 102 on the metal layer 94 to prevent migration of the metal layer material to other layers. Preventing this migration helps the LED chip 80 maintain efficient operation through its lifetime.

An active structure hole 104 can be included passing through the adhesion layer 96, reflective layer 92, and p-type layer 84, to expose the n-type layer 86. A passivation layer 106 is included on the barrier layer and the side surfaces of the active structure hole 104. The passivation layer protects and provides electrical insulation between the contacts and the layers below as described in more detail below. The passivation layer can comprise many different materials, such as a dielectric material.

Passivation layer hole 108 can be formed through the passivation layer 106 to the barrier layer 102 and/or the metal layer 94. A p-contact 110 can then be deposited in the passivation layer hole 108, with the p-contact 110 providing an electrical signal that can pass to the p-type layer 84. An electrical signal applied to the p-contact passes through the barrier layer 102, through the vias 100, and to the current spreading layer 90 through which it is spread to the p-type layer 84. Similarly, an n-contact is formed on the passivation layer and through the active structure hole 104, with the n-contact 112 providing an electrical path for an electrical signal to be applied to the n-type layer 86. A signal applied across the p-contact 110 and the n-contact 112 is conducted to the p-type layer 84 and the n-type layer 86, causing the LED chip to emit light from its active layer 88.

The p-contact 110 and the n-contact 112 can comprise many different materials such as Au, copper (Cu) nickel (Ni), indium (In), aluminum (Al), silver (Ag), tin (Sn), platinum (Pt) or combinations thereof. In still other embodiments they can comprise conducting oxides and transparent conducting oxides such as ITO, nickel oxide, zinc oxide, cadmium tin oxide, indium oxide, tin oxide, magnesium oxide, ZnGa₂O₄, ZnO₂/Sb, Ga₂O₃/Sn, AgInO₂/Sn, In₂O₃/Zn, CuAlO₂, LaCuOS, CuGaO₂ and SrCu₂O₂. The choice of material used can depend on the location of the contacts as well as the desired electrical characteristics such as transparency, junction resistivity and sheet resistance.

As described above, the LED chip 80 is arranged for flip-chip mounting. In operation, the p-contact 110 and n-contact 112 are bonded to a surface, such as a printed circuit board (PCB), with electrical paths for applying an electrical signal to the LED chip 80. In most cases, the p-contact 110 and n-contact 112 are on the bottom surface, and light that is emitted toward the bottom of the LED chip risks being at least partially absorbed, such as by the PCB. The reflective layer 92 and metal layer 94 are arranged below the active layer 88 so that light emitted toward the bottom is reflected back up to contribute to useful LED chip emission. The reflective layer 92 reflects most light by TIR, with the majority of the remainder of the light being reflected by metal layer 94.

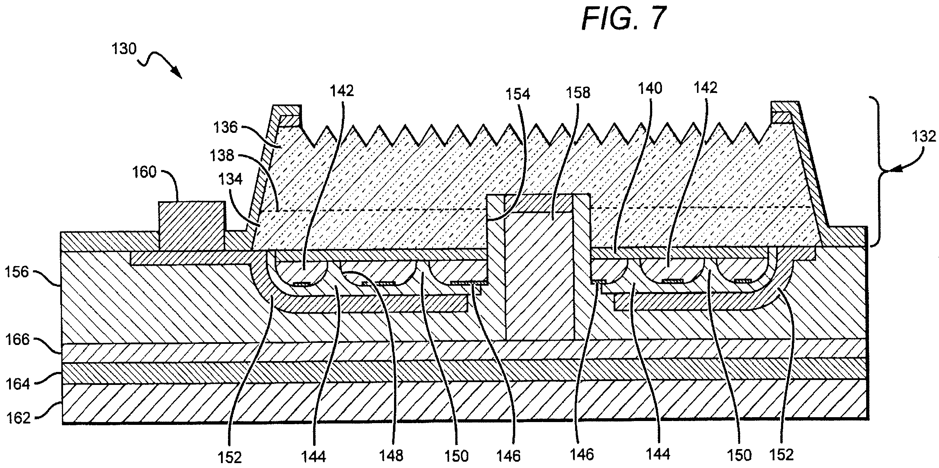

FIG. 7, shows another embodiment of a LED chip 130 according to the present invention that is flip-chip mounted onto a submount or substrate for use. The LED chip has many layers similar to those in the embodiment shown in FIG. 6 and described above including an active structure 132 comprising an p-type layer 134, n-type layer 136 and an active layer 138. A thin ITO current spreading layer 140 is included on the p-type layer 134 to spread current to the p-type layer 134 during operation. A reflective layer 142 is included on the current spreading layer as described above, with the SiO₂ reflective layer embodiments providing an IR step with the active structure 132 to promote TIR. A metal layer 144 is included on the reflective layer 142 with a TiON adhesion layer between the two.

Reflective layer holes 148 are formed through the adhesion layer 146 and the reflective layer 142, with the metal layer 144 material forming vias 150 though the reflective layer 142. A barrier layer 152 is included on the metal layer 144 to prevent migration of metal layer materials as described above. An active structure hole 154 is included through the adhesion layer 146, reflective layer 142, current spreading layer 140 and the p-type layer 134. A passivation layer 156 is included on the barrier layer and the side surfaces of the active structure hole 154 and n-contact via or contact 158 is included in the active structure hole for applying an electrical signal to the n-type layer 136.

In this embodiment, the passivation layer 156 and the barrier layer 152 extend beyond the edge of the active structure 132 to form a mesa where a p-contact 160 can be formed on the barrier layer 152. An electrical signal applied to the p-contact 160 is conducted to the p-type layer through the barrier layer 152, reflective layer 142 and the current spreading layer 140. Accordingly, an electrical signal applied across the p-contact 160 and the n-contact/via 150 is conducted to the p-type layer 134 and n-type layer 136, causing the active layer 138 to emit light.

The growth substrate for LED chip 130 has been removed, and the top surface of the n-type layer is textured for light extraction. To provide mechanical stabilization, the LED chip 130 is flip-chip mounted to a silicon (Si) submount/substrate 162, with a bond metal layer 164 and blanket mirror 166 between the substrate 162 and the active structure 132. The blanket mirror 166 can be made of many different materials, with a suitable material being Al. The blanket mirror 166 helps to reflect LED light that escapes reflection by the reflective layer 142 and the metal layer 144, such as light that passes through the active structure hole 154.

The reflective layer 142 and the metal layer 144 are arranged between the LED chip's active structure 132 and the substrate 162 so that light emitted by the active structure 132 toward the substrate 162 can be reflected back to contribute to useful LED light emission. This reduces the amount of light that can be absorbed by structures such as the submount 162, with the embodiments according to present invention promoting reflection by TIR instead of reflection off metal layers, to further reduce light loss due to absorption.

It is understood that many different materials can be used in the different features in the embodiments according to the present invention, and that the features can be arranged in many different ways beyond the embodiments above. In some embodiments, the first reflective layer can comprise materials with lower indexes of refraction, such as air or other gasses. The fabrication of such devices can be somewhat more complex, but the resulting index of refraction for the reflective layer can be as low as approximately 1.

Although the present invention has been described in detail with reference to certain preferred configurations thereof, other versions are possible. Therefore, the scope of the invention should not be limited to the versions described above. The scope of the present invention is defined by the claims.

## Claims

1. A light emitting diode (LED) chip (80; 130), comprising:
an active LED structure (82; 132) comprising an active layer (88; 138) between two oppositely doped layers (84, 86; 134, 136), said active layer (88; 138) configured to emit light in response to an electrical signal applied to said oppositely doped layers (84, 86; 134, 136);
a first reflective layer (92; 142) adjacent one of said oppositely doped layers (84, 86; 134, 136), and having an index of refraction different than said active LED structure (82; 132), said first reflective layer (92; 142) configured to reflect at least some active layer light;
a second reflective layer (94; 144) on said first reflective layer (92; 142), said second reflective layer (94; 144) configured to reflect light not reflected by said first reflective layer (92; 142);
a barrier layer (102; 152) on said second reflective layer (94; 144);
vias (100; 150) through said first reflective layer (92; 142), wherein said second reflective layer (94;144) forms said vias (100; 150), and wherein said second reflective layer (94; 144) is a metal layer;
a passivation layer (106; 156) on said barrier layer (102 152), where said passivation layer (106; 156) is electrically insulating;
an adhesion layer (96; 146) between said first reflective layer (92; 142) and said second reflective layer (94; 144); and
a current spreading layer (90; 140) between said first reflective layer (92; 142) and said active LED structure (82; 132);
wherein the first reflective layer (94;144) comprises a dielectric material and has a thickness in a range from 0.3 µm to 0.7 µm; and
wherein said second reflective layer (94; 144) that forms said vias (100) is arranged through said first reflective layer (92; 142),
**characterised in that**
said second reflective layer that forms said vias is arranged through said adhesion layer (96; 146) to directly contact said current spreading layer.

2. The LED chip of claim 1, wherein said first reflective layer (92; 142) comprises SiO₂, SiN, Si, Ge, MgOx, MgNx, ZnO, SiNx, SiOx, AIN or alloys or combinations thereof.

3. The LED chip of claim 1 or 2, wherein said current spreading layer (90; 140) comprises ITO.

4. The LED chip of any one of the preceding claims, wherein said vias (100) are also through said adhesion layer (96; 146).

5. The LED chip of any one of the preceding claims, wherein said first reflective layer (92; 142) has an index Z of Z refraction that is at least 50% different than the active LED structure's index of refraction.

6. The LED chip of any one of the preceding claims, wherein said first reflective layer (92; 142) has an index of refraction that is lower than the active LED structure's index of refraction.

7. The LED chip of any one of the preceding claims, further comprising an active structure hole (104; 154) exposing one of said oppositely doped layers (86; 136), wherein said passivation layer (106; 156) is on the side surfaces of said active structure hole (104; 154).

8. The LED chip of claim 7, further comprising a contact (112; 158) through said active structure hole (104; 154) to said one of said oppositely doped layers (86; 136) for applying an electrical signal to said one of said oppositely doped layers (86; 136).

9. The LED chip of any one of the preceding claims, further comprising a passivation layer hole (108) through said passivation layer (106) to said barrier layer (102) and/or said second reflective layer (94).

10. The LED chip of claim 8, further comprising a contact (110) in said passivation layer hole (108) for applying an electrical signal to one of said oppositely doped layers (84).

## Patentansprüche

1. Chip für lichtemittierende Diode (LED) (80; 130), umfassend:
eine aktive LED-Struktur (82; 132), umfassend eine aktive Schicht (88; 138) zwischen zwei gegensätzlich dotierten Schichten (84, 86; 134, 136), wobei die aktive Schicht (88; 138) konfiguriert ist, um als Reaktion auf ein elektrisches Signal, welches an die gegensätzlich dotierten Schichten (84, 86; 134, 136) angelegt wurde, Licht zu emittieren;
eine erste reflektierende Schicht (92; 142) benachbart zu einer der gegensätzlich dotierten Schichten (84, 86; 134, 136) und mit einem Brechungsindex, welcher sich von der aktiven LED-Struktur (82; 132) unterscheidet, wobei die erste reflektierende Schicht (92; 142) konfiguriert ist, um zumindest etwas Licht der aktiven Schicht zu reflektieren;
eine zweite reflektierende Schicht (94; 144) auf der ersten reflektierenden Schicht (92; 142), wobei die zweite reflektierende Schicht (94; 144) konfiguriert ist, um Licht zu reflektieren, welches nicht von der ersten reflektierende Schicht (92; 142) reflektiert wurde;
eine Sperrschicht (102; 152) auf der zweiten reflektierenden Schicht (94; 144);
Durchverbindungen (100; 150) durch die erste reflektierende Schicht (92; 142), wobei die zweite reflektierende Schicht (94; 144) die Durchverbindungen (100; 150) bildet, und wobei die zweite reflektierende Schicht (94; 144) eine Metallschicht ist;
eine Passivschicht (106; 156) auf der Sperrschicht (102; 152), wobei die Passivschicht (106; 156) elektrisch isolierend ist;
eine Haftschicht (96; 146) zwischen der ersten reflektierenden Schicht (92; 142), und der zweiten reflektierenden Schicht (94; 144); und
eine Stromaufweitungsschicht (90; 140) zwischen der ersten reflektierenden Schicht (92; 142), und der aktiven LED-Struktur (82; 132);
wobei die erste reflektierende Schicht (94; 144) ein dielektrisches Material umfasst und eine Dicke in einem Bereich von 0,3 µm bis 0,7 µm aufweist; und
wobei die zweite reflektierende Schicht (94; 144), welche die Durchverbindungen (100) bildet, durch die erste reflektierende Schicht (92; 142) angeordnet ist,
**dadurch gekennzeichnet, dass**
die zweite reflektierende Schicht, welche die Durchverbindungen bildet, durch die Haftschicht (96; 146) angeordnet ist, um die Stromaufweitungsschicht direkt zu kontaktieren.

2. LED-Chip nach Anspruch 1, wobei die erste reflektierende Schicht (92; 142) SiO₂, SiN, Si, Ge, MgOx, MgNx, ZnO, SiNx, SiOx, AIN oder Legierungskombinationen davon umfasst.

3. LED-Chip nach Anspruch 1 oder 2, wobei die Stromaufweitungsschicht (90; 140) ITO umfasst.

4. LED-Chip nach einem der vorstehenden Ansprüche, wobei die Durchverbindungen (100) auch durch die Haftschicht (96; 146) verlaufen.

5. LED-Chip nach einem der vorstehenden Ansprüche, wobei die erste reflektierende Schicht (92; 142) einen Brechungsindex aufweist, welcher sich um zumindest 50 % von dem Brechungsindex der aktiven LED-Struktur unterscheidet.

6. LED-Chip nach einem der vorstehenden Ansprüche, wobei die erste reflektierende Schicht (92; 142) einen Brechungsindex aufweist, welcher niedriger ist als der Brechungsindex der aktiven LED-Struktur.

7. LED-Chip nach einem der vorstehenden Ansprüche, weiter ein Loch (104; 154) in der aktiven Struktur umfassend, welches eine der gegensätzlich dotierten Schichten (86; 136) freilegt, wobei die Passivschicht (106; 156) auf den Seitenflächen des Lochs (104; 154) in der aktiven Struktur ist.

8. LED-Chip nach Anspruch 7, weiter einen Kontakt (112; 158) durch das Loch (104; 154) in der aktiven Struktur zu einer der gegensätzlich dotierten Schichten (86; 136) umfassend, um ein elektrisches Signal an eine der gegensätzlich dotierten Schichten (86; 136) anzulegen.

9. LED-Chip nach einem der vorstehenden Ansprüche, weiter ein Passivschicht-Loch (108) durch Passivschicht (106) zu der Sperrschicht (102) und/oder der zweiten reflektierenden Schicht (94) umfassend.

10. LED-Chip nach Anspruch 8, weiter einen Kontakt (110;) in dem Passivschicht-Loch (108) umfassend, um ein elektrisches Signal an eine der gegensätzlich dotierten Schichten (84) anzulegen.

## Revendications

1. Puce de diode électroluminescente (DEL) (80 ; 130), comprenant :
une structure DEL active (82 ; 132) comprenant une couche active (88 ; 138) entre deux couches dopées de manière opposée (84, 86 ; 134, 136), ladite couche active (88 ; 138) étant configurée pour émettre une lumière en réponse à un signal électrique appliqué auxdites couches dopées de manière opposée (84, 86 ; 134, 136) ;
une première couche réfléchissante (92 ; 142) adjacente à l'une desdites couches dopées de manière opposée (84, 86 ; 134, 136), et présentant un indice de réfraction différent de celui de ladite structure DEL active (82 ; 132), ladite première couche réfléchissante (92 ; 142) étant configurée pour réfléchir au moins une certaine lumière de couche active ;
une seconde couche réfléchissante (94 ; 144) sur ladite première couche réfléchissante (92 ; 142), ladite seconde couche réfléchissante (94 ; 144) étant configurée pour réfléchir une lumière non réfléchie par ladite première couche réfléchissante (92 ; 142) ;
une couche barrière (102 ; 152) sur ladite seconde couche réfléchissante (94 ; 144);
des trous d'interconnexion (100; 150) à travers ladite première couche réfléchissante (92 ; 142), dans laquelle ladite seconde couche réfléchissante (94 ; 144) forme lesdits trous d'interconnexion (100 ; 150), et dans lequel ladite seconde couche réfléchissante (94 ; 144) est une couche métallique ;
une couche de passivation (106 ; 156) sur ladite couche barrière (102 ; 152), ladite couche de passivation (106 ; 156) étant électriquement isolante ;
une couche d'adhérence (96 ; 146) entre ladite première couche réfléchissante (92 ; 142) et ladite seconde couche réfléchissante (94 ; 144) ; et
une couche d'étalement de courant (90 ; 140) entre ladite première couche réfléchissante (92 ; 142) et ladite structure LED active (82 ; 132) ;
dans laquelle ladite première couche réfléchissante (94; 144) comprend un matériau diélectrique et présente une épaisseur dans une plage de 0,3 µm à 0,7 µm ; et
dans laquelle ladite seconde couche réfléchissante (94; 144) formant lesdits trous d'interconnexion (100) est agencée à travers ladite première couche réfléchissante (92 ; 142),
**caractérisée en ce que**
ladite seconde couche réfléchissante formant lesdits trous d'interconnexion est agencée à travers ladite couche d'adhérence (96 ; 146) pour être directement en contact avec ladite couche d'étalement de courant.

2. Puce DEL selon la revendication 1, dans laquelle ladite première couche réfléchissante (92 ; 142) comprend SiO₂, SiN, Si, Ge, MgOx, MgNx, ZnO, SiNx, SiOx, AIN ou des alliages ou des combinaisons de ceux-ci.

3. Puce DEL selon la revendication 1 ou 2, dans laquelle ladite couche d'étalement de courant (90 ; 140) comprend ITO.

4. Puce DEL selon l'une quelconque des revendications précédentes, dans laquelle lesdits trous d'interconnexion (100) sont également à travers ladite couche d'adhérence (96 ; 146).

5. Puce DEL selon l'une quelconque des revendications précédentes, dans laquelle ladite première couche réfléchissante (92 ; 142) présente un indice de réfraction qui est différent d'au moins 50 % de l'indice de réfraction de la structure DEL active.

6. Puce DEL selon l'une quelconque des revendications précédentes, dans laquelle ladite première couche réfléchissante (92 ; 142) présente un indice de réfraction qui est inférieur à l'indice de réfraction de la structure DEL active.

7. Puce DEL selon l'une quelconque des revendications précédentes, comprenant en outre un trou de structure active (104 ; 154) exposant l'une desdites couches dopées de manière opposée (86 ; 136), dans laquelle ladite couche de passivation (106 ; 156) est sur les surfaces latérales dudit trou de structure active (104 ; 154).

8. Puce DEL selon la revendication 7, comprenant en outre un contact (112 ; 158) à travers ledit trou de structure active (104 ; 154) jusqu'à ladite une desdites couches dopées de manière opposée (86 ; 136) pour appliquer un signal électrique à ladite une desdites couches dopées de manière opposée (86 ;136).

9. Puce DEL selon l'une quelconque des revendications précédentes, comprenant en outre un trou de couche de passivation (108) à travers ladite couche de passivation (106) jusqu'à ladite couche barrière (102) et/ou ladite seconde couche réfléchissante (94).

10. Puce DEL selon la revendication 8, comprenant en outre un contact (110) dans ledit trou de couche de passivation (108) pour appliquer un signal électrique à l'une desdites couches dopées de manière opposée (84).
